(19) **Europäisches Patentamt / European Patent Office / Office européen des brevets**

(11) **EP 1 110 242 B1**

(12) **FASCICULE DE BREVET EUROPEEN**

(45) Date de publication et mention de la délivrance du brevet:
**19.11.2008 Bulletin 2008/47**

(21) Numéro de dépôt: **00931324.8**

(22) Date de dépôt: **19.05.2000**

(51) Int Cl.:
*H01L 23/36* (2006.01)   *H01L 25/07* (2006.01)
*H01L 23/373* (2006.01)   *H01L 23/367* (2006.01)

(86) Numéro de dépôt international:
**PCT/FR2000/001375**

(87) Numéro de publication internationale:
**WO 2000/072379 (30.11.2000 Gazette 2000/48)**

(54) **CAPACITE THERMIQUE POUR COMPOSANT ELECTRONIQUE FONCTIONNANT EN IMPULSIONS LONGUES**

THERMISCHE MASSE FÜR LANGPULS-ELEKTRONIKBAUTEILE

THERMAL CAPACITY FOR ELECTRONIC COMPONENT OPERATING IN LONG PULSES

(84) Etats contractants désignés:
**DE GB**

(30) Priorité: **21.05.1999 FR 9906513**

(43) Date de publication de la demande:
**27.06.2001 Bulletin 2001/26**

(73) Titulaire: **Thales**
**75008 Paris (FR)**

(72) Inventeurs:
• **FLORIOT, Didier,**
**Thomson-CSF Proprieté Intel.**
**F-94117 Arcueil Cedex (FR)**
• **DELAGE, Sylvain,**
**Thomson-CSF Proprieté Intel.**
**F-94117 Arcueil Cedex (FR)**
• **CASSETTE, Simone,**
**Thomson-CSF Proprieté Intel.**
**F-94117 Arcueil Cedex (FR)**
• **DUCHEMIN, Jean-Pascal,**
**Thomson-CSF Proprieté Intel**
**F-94117 Arcueil Cedex (FR)**

(56) Documents cités:
| EP-A- 0 029 334 | EP-A- 0 756 322 |
| WO-A-95/31006 | DE-A- 2 839 043 |
| FR-A- 2 328 286 | US-A- 3 761 783 |

**EP 1 110 242 B1**

**Description**

L'invention concerne un dispositif à capacité thermique pour composants électroniques fonctionnant en impulsion longue. Elle est plus particulièrement applicable aux transistors bipolaires à hétérojonction et notamment à de tels transistors fonctionnant en hyperfréquences.

Les composants hyperfréquences fonctionnant en impulsions d'une durée de plusieurs dizaines à plusieurs centaines de micro secondes voire, au-delà de la milli seconde sont utilisés pour réaliser des équipements du type radars de contrôle de trafic aérien.

Dans de tels composants, la température de la jonction varie au cours de l'impulsion, elle s'élève d'abord proportionnellement à la racine du temps pour atteindre un palier haut si la durée est suffisamment longue, elle redescend ensuite à la fin de l'impulsion avec la même rapidité pour atteindre un palier bas si le « duty cycle » est nettement plus petit que l'unité.

L'élévation maximale de température $\Delta T_{max}$ de la partie active du composant que l'on peut appeler la jonction, pendant une impulsion de longueur $\tau$ est de la forme

$$\Delta T_{max} = (1\text{-}D) \times \Delta T_{pulse} + D\,\Delta T_{cw,}$$

où :

D est le rapport cyclique,
$\Delta T_{pulse}$ l'élévation de température dans l'impulsion,
et $\Delta T_{cw}$ l'élévation de température qui correspondrait à un fonctionnement continu du composant avec le même niveau de puissance.

L'élévation de température de la jonction pendant une impulsion de fonctionnement d'une durée $\tau$ générant une puissance thermique $P_{th}$ sur une surface S est :

$$\Delta T_{pulse} = (P_{th}/S).(\tau/\lambda.\rho.c_p)^{1/2},$$

où

$\lambda$ représente la conductivité thermique du matériau considéré ;
$\rho$ sa masse volumique

et

$c_p$ sa capacité calorifique

La profondeur de pénétration de la chaleur dans le matériau semiconducteur pendant la durée d'une impulsion appelée longueur de diffusion thermique est :

$$L = (\tau.\lambda/\rho.c_p)^{1/2}$$

L'énergie thermique générée pendant l'impulsion est :

$$E_{th} = 0,5.S.\lambda.\rho.c_p)^{1/2}.\Delta T_{pulse,}$$

où $(\lambda.\rho.c_p)^{1/2}$, représente l'effusivité thermique du matériau considéré, c'est-à-dire son aptitude à évacuer rapidement la chaleur de l'endroit où elle est générée.

Un transistor bipolaire à hétérojonction (HBT) élémentaire est composé d'un émetteur, d'une base et d'un collecteur.

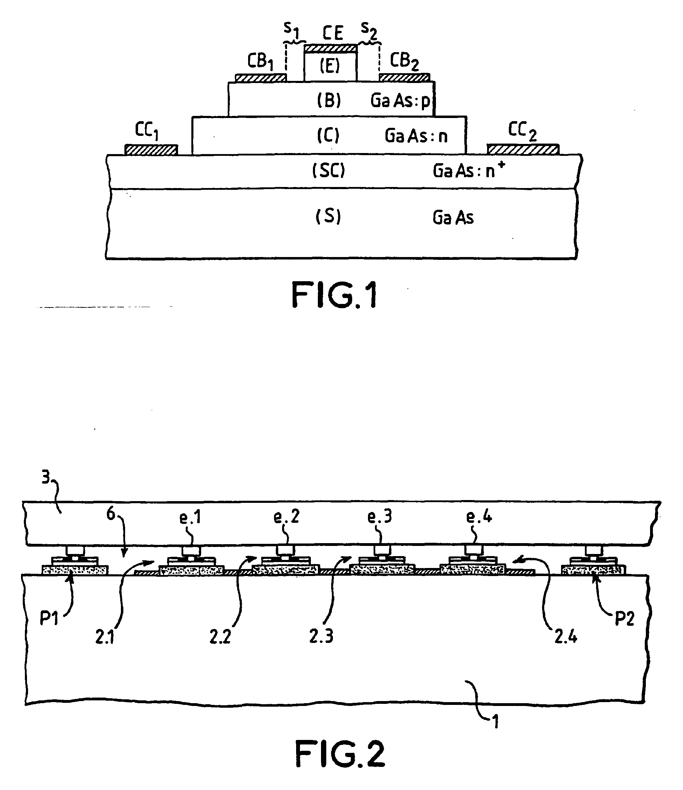

Ce type de transistor comprend (voir figure 1) :

- un substrat S semi-isolant en GaAs ;
- une couche de sous-collecteur SC en GaAs dopée n (concentration typiquement de l'ordre de $4.10^{18}cm^{-3}$ ;
- une couche de collecteur C en GaAs dopée n (concentration typiquement de l'ordre de $2.10^{16}cm{-3}$), GaInP ou autre semiconducteur ;
- une couche de base B en GaAs dopée p (concentration typiquement de l'ordre de $7.10^{19}cm^{-3}$) ;
- une couche d'émetteur E en GaInP dopée n (concentration typiquement $3.10^{17}cm^{-3}$).

Sur la couche de sous-collecteur SC sont réalisés des contacts de collecteur $CC_1$ et $CC_2$, sur la couche de base B sont réalisés des contacts de base CB1 et CB2, et sur la couche d'émetteur E, un contact d'émetteur CE.

Un transistor HBT de puissance hyperfréquence est constitué d'un grand nombre de modules élémentaires montés en parallèle. Afin d'homogénéiser l'écoulement de la chaleur au travers du substrat, les émetteurs de quelques microns de largeur, typiquement deux microns sont séparés de quelques dizaines de microns, typiquement la trentaine de microns. Il est connu sur une telle structure de superposer un shunt thermique tel que cela est décrit dans la demande de brevet français n° 97 06682 ayant le numéro de publication FR-A-2 764 118. Ce shunt thermique évacue une partie de la chaleur générée par le haut de l'émetteur pour l'évacuer ensuite au travers de l'espace libre entre deux transistors élémentaires espacés, typiquement d'une dizaine de microns. Ainsi, nous pouvons considérer que la surface à prendre en compte pour évacuer la chaleur est bien supérieure à la surface totale des doigts d'émetteurs, elle se rapproche de la surface qui enveloppe toute la zone couverte par les transistors.

Quand un transistor à hétérojonction fonctionne en impulsions longues (typiquement supérieures à 100 micro secondes, l'élévation de sa température pendant une impulsion peut être voisine ou supérieure à 100°C, il s'ensuit un certain nombre d'inconvénients :

1) la puissance maximale autorisée est souvent limitée par la température atteinte pendant une impulsion plutôt que par la puissance moyenne à évacuer ;
2) la puissance diminue quand la température s'élève ;
3) la phase évolue quand la température s'élève.

Il est connu du document EP-A- 0 756 322, un procédé de réalisation d'un transistor bipolaire à hétérojonction comportant notamment les étapes suivantes :

- la réalisation sur un substrat de l'alternance de couche de sous-collecteur, couche de collecteur, couche d'émetteur ;
- la gravure des différentes couches de manière à réaliser des transistors élémentaires ;
- la réalisation de contacts de base ;
- le dépôt d'une couche constituant un drain thermique ;
- la fixation d'une plaque de dissipation thermique en contact avec la couche de drain thermique.

Dans ce contexte, la présente invention propose un nouveau type de composant permettant de limiter l'amplitude de l'augmentation de la température et d'atteindre très rapidement un régime établi.

L'invention concerne un composant électronique selon la revendication 1 comportant sur un substrat , des transistors bipolaires élémentaires à hétérojonction disposés côte à côte, une couche conductrice de l'électricité et de la chaleur ainsi qu'un dissipateur thermique étant commun auxdits transistors élémentaires, lesdits transistors élémentaires, en forme de mésa, étant constitués d'un empilement de couches différentes déterminées de sous-collecteur, de collecteur, de base et d'émetteur, le composant étant **caractérisé en ce que :**

- le composant comporte deux plots passifs et conducteurs thermiques situés de part et d'autre des transistors élémentaires, lesdits plots ayant la même structure et la même composition que les transistors élémentaires, chaque transistor élémentaire ayant en plus sur sa partie supérieure une couche de contact électrique d'émetteur ;
- la couche de contact électrique d'émetteur de chaque transistor élémentaire est revêtue par la couche conductrice de l'électricité et de la chaleur surmontée par l'élément dissipateur thermique en contact avec ladite couche conductrice ;
- l'élément dissipateur thermique est de forme plane ;
- lesdits plots sont revêtus également par ladite couche conductrice de l'électricité et de la chaleur ;
- il comporte en outre un matériau isolant remplissant les espaces entre les différents transistors élémentaires et les espaces entre les transistors élémentaires et les plots, ledit matériau isolant affleurant la face supérieure des couches de contact d'émetteurs des transistors élémentaires et la face supérieure des plots de façon que l'ensemble constitue une surface plane.

L'invention concerne également un procédé de réalisation d'un transistor bipolaire à hétérojonction selon la revendication 7 comportant les phases suivantes :

■ réalisation sur un substrat (1) de l'alternance des couches suivantes avec les matériaux indiqués à titre d'exemple entre parenthèse :

- couche de sous-collecteur (GaAs : n+)
- couche de collecteur (GaAs : $\mu$)
- couche de base
- couche d'émetteur (GaInP : n)

■ gravure des différentes couches définies ci-dessus de façon à réaliser des empilements en forme de mésa ;
■ réalisation de contacts de base et de collecteur ;
■ réalisation de contacts d'émetteur au niveau de certains empilements pour former des transistors élémentaires , les autres empilements constituant des plots passifs et conducteurs thermiques ;
■ remplissage à l'aide d'un matériau isolant, des espaces libres entre les différents transistors élémentaires et entre les transistors élémentaires et les plots et planification de façon à obtenir une surface libre affleurant les faces supérieures des transistors élémentaires et des plots ;
■ dépôt d'une couche conductrice de l'électricité et de la chaleur constituant un drain thermique faisant contact avec les faces supérieures des transistors élémentaires et des plots, lesdites faces supérieures des transistors étant des couches de contact électrique d'émetteur ;
■ fixation d'une plaque de dissipation thermique en contact avec la couche de drain thermique.

Les différents objets et caractéristiques de l'invention apparaîtront plus clairement dans la description qui va suivre et dans les figures annexées qui représentent :

- la figure 1, des transistors HBT connus dans la technique et décrits précédemment ;
- la figure 2, un exemple de réalisation du dispositif de l'invention ;
- la figure 3, un exemple de réalisation de l'invention appliqué à plusieurs transistors HBT ;
- la figure 4, une variante de l'exemple de réalisation de la figure 2.

En se reportant à la figure 2, on va donc maintenant décrire un exemple de réalisation du dispositif de l'invention. Ce dispositif comporte, réalisé sur un substrat 1, un transistor constitué d'un ensemble de transistors élémentaires 2.1 à 2.4. Chaque transistor élémentaire est constitué d'un empilement de couches telles que décrites en relation avec la figure 1. Ces transistors élémentaires sont réalisés collectivement de telle sorte que leurs parties supérieures terminées chacune par un contact d'émetteur e.1 à e.4 sont toutes quasiment au même niveau.
Selon l'invention, de chaque côté de l'ensemble de transistors élémentaires (ou au moins d'un côté) sont réalisés des plots P1 et P2. Préférentiellement, ces plots sont réalisés en même temps, dans les mêmes couches et selon les mêmes techniques que les transistors élémentaires 2.1 à 2.4. Ils ont alors la même forme que ces transistors et la même hauteur. Par contre, ces plots sont passifs du point de vue électronique et ne sont donc pas le siège d'échauffement. Ils sont simplement conducteurs thermiques.
Les espaces entre les transistors élémentaires et entre ces plots sont remplis d'un matériau isolant dont la partie supérieure est plaquée et affleure les parties supérieures des transistors élémentaires et des plots. L'ensemble présente une face supérieure 6 qui est plane.
Sur la face supérieure 6 est placée une plaque bonne conductrice de la chaleur. De préférence, cette plaque de dissipation thermique est donc plane. Cette plaque est en contact avec les parties supérieures des transistors élémentaires et des plots, voire même elle est brasée à ces parties supérieures.
Dans ces conditions, la chaleur des transistors sera stockée dans la plaque durant chaque impulsion, puis se dissipera vers le substrat 1 par les plots P1 et P2.
Selon un mode de réalisation préféré, la plaque 3 est en diamant. Elle peut être brasée aux faces supérieures des transistors et des plots à l'aide d'un alliage à base d'étain.

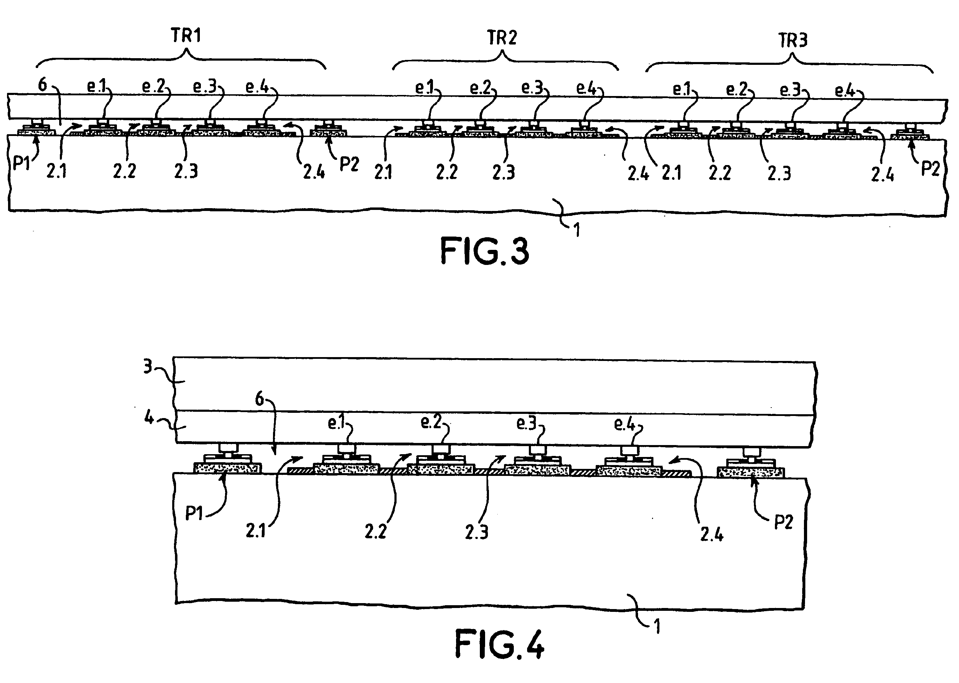

La figure 3 représente un mode de réalisation comportant plusieurs transistors TR1 à TR3. La plaque de dissipation thermique peut être commune à tout ou partie des transistors. On peut prévoir des plots tels que P1, P2 de chaque côté du transistor mais cela n'est pas obligatoire comme cela a été représenté pour les transistors TR2 et TR3.
Selon la figure 4, on a prévu entre la plaque de dissipation thermique, une couche 4 constituant un shunt thermique en contact avec les parties supérieures des transistors et des plots. Cette couche est de préférence métallique, en or par exemple. La plaque de dissipation thermique 3 est alors brasée à cette couche 4.
Ainsi, selon l'invention, la plaque de dissipation thermique 3 remplit le rôle d'une capacité thermique sur les transistors bipolaire à hétérojonction pour absorber rapidement la quasi totalité de la chaleur générée pendant une impulsion plus vite que ne le fait le matériau semiconducteur lui-même qu'il soit à base d'arséniure de gallium, de phosphure d'indium, ou même de silicium ou encore de silicium germanium, voire même de carbure de silicium.

L'invention consiste donc plus précisément à braser au-dessus du shunt thermique 4 un parallélépipède 3 en diamant synthétique polycristallin, poli et métallisé sur la face en contact avec le shunt thermique 4.

Selon une autre variante de réalisation, le dissipateur thermique peut être réalisé par croissance d'un matériau possédant une effusivité thermique proche du diamant.

L'effusivité thermique $\{(\lambda.p.c_p)^{1/2}\}$ du diamant est environ 8 fois supérieur à celle de l'arséniure de gallium comme on peut le calculer à partir du tableau ci-dessous.

| Matériau | Conductivité thermique $\lambda$ (W/cm°C) | Chaleur spécifique $C_p$ (Joule/gramme) | Densité $\rho$ (gramme/cm³) | Effusivité |
|---|---|---|---|---|
| GaAs | 0,3 | 0,3 | 5,3 | 0,68 |
| Silicium | 0,83 | 0,7 | 2,33 | 1,16 |
| Diamant | 10 | 0,52 | 3,52 | 4,27 |

L'épaisseur du diamant doit être voisine ou supérieure à la longueur de la diffusion thermique « L » pendant une impulsion $\tau$, soit égale ou supérieure à 450 microns pour une impulsion de 200 microsecondes.

Ainsi, si l'on considère comme négligeable l'épaisseur du shunt thermique 4 et son effet en transitoire, à l'interface or/arséniure de gallium, la température est la même par continuité et les quantités de chaleur qui sont évacuées de part et d'autre sont proportionnelles à leurs effusivité thermiques.

Si $\Delta T_0$ et $\Delta T_1$ sont respectivement les élévations de températures de la jonction pendant une impulsion avec d'une part le dispositif seul avec son shunt thermique et d'autre part le dispositif sur lequel un parallélépipède de diamant a été intimement brasé, collé ou soudé, nous avons :

$$\Delta T_1 \text{ et } \Delta T_0.\text{effusivité}_{GaAs}/(\text{effusivité}_{GaAs} + \text{effusivité}_{diamant})$$

soit environ $\Delta T_0/9$.

La chaleur ainsi stockée dans le parallélépipède de diamant 4 pendant une impulsion est ensuite évacuée entre deux impulsions en repassant par le shunt d'or au travers du matériau semiconducteur 5 et 5' qui peut être de l'arséniure de gallium comme dans le cas pris en exemple. Comme le temps entre deux impulsions est typiquement dix fois plus grand que celui d'une impulsion, cette évacuation contribue peu à la résistance thermique de l'ensemble.

En mode continu, il est possible selon l'invention de réduire considérablement la résistance thermique d'un transistor bipolaire à shunt thermique.

Ainsi, il est possible de connecter la capacité thermique décrite précédemment à la masse thermique du transistor sur une plus large base afin d'évacuer plus commodément la chaleur moyenne générée par le transistor. Il faut dans ce cas appuyer le parallélépipède de diamant sur deux piliers d'arséniure de gallium laissés à la même hauteur que les émetteurs au moment de la gravure de ces derniers. La résistance thermique est alors inversement proportionnelle à la surface que l'on peut accorder à la construction de ces piliers.

Un composant tel que représenté en figure 2 peut être réalisé selon le procédé suivant :

■ réalisation sur un substrat (1) de l'alternance de couches suivantes avec les matériaux indiqués à titre d'exemple entre parenthèse :

- couche de sous-collecteur (GaAs : n+)
- couche de collecteur (GaAs : $\mu$)
- couche d'émetteur (GaInP : n)

■ gravure des différentes couches ci-dessus de façon à réaliser les transistors élémentaires 2.1 à 2.4 ainsi que les plots P1 et P2 ;

■ réalisation des contacts de base (CB1, CB2) et de collecteur (CC1, CC2) ;

■ remplissage, à l'aide d'un matériau isolant, des espaces libres entre les transistors et les plots et planification de façon à obtenir une surface affleurant les faces supérieures des transistors et des plots ;

■ dépôt d'une couche constituant du drain thermique faisant contact avec les faces supérieures des transistors et des plots ;

■ fixation d'une plaque de dissipation thermique en contact avec la couche de drain thermique.

Les avantages de notre procédé sont les suivants par rapport aux solutions classiques :

- Réduction de la température de (jonction) fonctionnement
- Diminution de la variation de la température de jonction dans les impulsions
- Perturbation limitée de l'environnement électromagnétique du composant permettant des adaptations rapides de designs
- Amélioration attendue de la fiabilité en liaison avec la température plus basse de fonctionnement
- Amélioration de la stabilité de la phase pendant les impulsions
- Augmentation de la puissance (Pout) maximale utilisable
- Amélioration de la fiabilité

L'invention a été décrite sous la forme d'applications aux transistors bipolaires à hétérojonction (HBT) mais elle est applicable à tout autre type de composant.

## Revendications

1. Composant électronique (TR1, TR2, TR3) comportant sur un substrat (S ; 1), des transistors bipolaires élémentaires à hétérojonction (2.1 à 2.4) disposés côte à côte, une couche (4) conductrice de l'électricité et de la chaleur ainsi qu'un dissipateur thermique (3) étant commun auxdits transistors élémentaires, lesdits transistors élémentaires, en forme de mésa, étant constitués d'un empilement de couches différentes déterminées de sous-collecteur (SC), de collecteur (C), de base (B) et d'émetteur (E), le composant étant **caractérisé en ce que :**

   - le composant comporte deux plots (P1 et P2) passifs et conducteurs thermiques situés de part et d'autre des transistors élémentaires, lesdits plots ayant la même structure et la même composition que les transistors élémentaires, chaque transistor élémentaire ayant en plus sur sa partie supérieure une couche de contact électrique d'émetteur (CE ; e.1 à e.4) ;
   - la couche de contact électrique d'émetteur de chaque transistor élémentaire est revêtue par la couche conductrice de l'électricité et de la chaleur surmontée par l'élément dissipateur thermique en contact avec ladite couche conductrice ;
   - l'élément dissipateur thermique est de forme plane ;
   - lesdits plots sont revêtus également par ladite couche conductrice de l'électricité et de la chaleur ;
   - il comporte en outre un matériau isolant remplissant les espaces entre les différents transistors élémentaires et les espaces entre les transistors élémentaires et les plots, ledit matériau isolant affleurant la face supérieure des couches de contact d'émetteurs des transistors élémentaires et la face supérieure des plots de façon que l'ensemble constitue une surface plane (6).

2. Composant selon la revendication 1, **caractérisé en ce que** le dissipateur thermique est une plaque de diamant.

3. Composant selon la revendication 2, **caractérisé en ce que** la plaque de diamant est brasée auxdits empilements des transistors et aux plots.

4. Composant selon la revendication 3, **caractérisé en ce que** la brasure est réalisée à l'aide d'un alliage à base d'étain.

5. Composant selon la revendication 2, **caractérisé en ce que** la plaque de diamant est en diamant polycristallin et que sa face en contact avec les empilements de couches et les plots est métallisée.

6. Composant selon l'une des revendications précédentes, **caractérisé en ce que** le dissipateur thermique est réalisé par croissance d'un matériau possédant une effusivité thermique proche de celle du diamant, de l'ordre de 4.

7. Procédé de réalisation d'un transistor bipolaire à hétérojonction (TR1, TR2, TR3) comportant les phases suivantes :

   ■ réalisation sur un substrat (1) de l'alternance des couches suivantes avec les matériaux indiqués à titre d'exemple entre parenthèse :

- couche de sous-collecteur (GaAs : n+)
- couche de collecteur (GaAs : μ)
- couche de base
- couche d'émetteur (GaInP : n)

■ gravure des différentes couches définies ci-dessus de façon à réaliser des empilements en forme de mésa ;
■ réalisation de contacts de base (CB1, CB2) et de collecteur (CC1, CC2) ;
■ réalisation de contacts d'émetteur (CE ; e1 à e4) au niveau de certains empilements pour former des transistors élémentaires (2.1 à 2.4), les autres empilements constituant des plots (P1 et P2) passifs et conducteurs thermiques ;
■ remplissage à l'aide d'un matériau isolant, des espaces libres entre les différents transistors élémentaires et entre les transistors élémentaires et les plots et planification de façon à obtenir une surface libre (6) affleurant les faces supérieures des transistors élémentaires et des plots ;
■ dépôt d'une couche (4) conductrice de l'électricité et de la chaleur constituant un drain thermique faisant contact avec les faces supérieures des transistors élémentaires et des plots, lesdites faces supérieures des transistors étant des couches de contact électrique d'émetteur ;
■ fixation d'une plaque (3) de dissipation thermique en contact avec la couche de drain thermique.

## Claims

1. Electronic component (TR1, TR2, TR3) comprising on a substrate (S;1), heterojunction elementary bipolar transistors (2.1 to 2.4) disposed side by side, an electrically and thermally conducting layer (4) and a heat sink (3) being common to said elementary transistors, said elementary transistors, mesa-shaped, consisting of a stack of determined different layers for sub-collector (SC), collector (C), base (B) and emitter (E), the component being **characterized in that:**

   - the component comprises two passive and heat-conducting pads (P1 and P2) situated on either side of the elementary transistors, said pads having the same structure and the same composition as the elementary transistors, each elementary transistor additionally having on its upper part an emitter electrical contact layer (CE; e.1 to e.4);
   - the emitter electrical contact layer of each elementary transistor is covered by the electrically and thermally conducting layer surmounted by the heat sink element in contact with said conducting layer;
   - the heat sink element is of plane shape;
   - said pads are also covered by said electrically and thermally conducting layer;
   - it furthermore comprises an insulating material filling the spaces between the various elementary transistors and the spaces between the elementary transistors and the pads, said insulating material being flush with the upper face of the emitter contact layers of the elementary transistors and the upper face of the pads in such a way that the assembly constitutes a plane surface (6).

2. Component according to Claim 1, **characterized in that** the heat sink is a diamond plate.

3. Component according to Claim 2, **characterized in that** the diamond plate is soldered to said stacks of the transistors and to the pads.

4. Component according to Claim 3, **characterized in that** the soldering is carried out with the aid of a tin-based alloy.

5. Component according to Claim 2, **characterized in that** the diamond plate is made of polycrystalline diamond and that its face in contact with the stacks of layers and the pads is metallized.

6. Component according to one of the preceding claims, **characterized in that** the heat sink is produced by growth of a material possessing a thermal effusivity close to that of diamond, of the order of 4.

7. Method of producing a heterojunction bipolar transistor (TR1, TR2, TR3) comprising the following phases:

   • producing on a substrate (1) the alternation of the following layers with the materials indicated by way of example between parentheses:

      - sub-collector layer (GaAs: n+)

- collector layer (GaAs:μ)
- base layer
- emitter layer (GaInP: n)

• etching the various layers defined above so as to produce mesa-shaped stacks;
• producing base contacts (CB1, CB2) and collector contacts (CC1, CC2);
• producing emitter contacts (CE; e1 to e4) at the level of certain stacks so as to form elementary transistors (2.1 to 2.4), the other stacks constituting passive and heat-conducting pads (P1 and P2);
• filling with the aid of an insulating material, the free spaces between the various elementary transistors and between the elementary transistors and the pads and planning so as to obtain a free surface (6) flush with the upper faces of the elementary transistors and pads;
• depositing an electrically and thermally conducting layer (4) constituting a heat drain making contact with the upper faces of the elementary transistors and pads, said upper faces of the transistors being emitter electrical contact layers;
• fixing a heat sinking plate (3) in contact with the heat drain layer.

**Patentansprüche**

1. Elektronikbauteil (TR1, TR2, TR3), umfassend auf einem Substrat (S; 1) Heterobipolar-Transistorelemente (2.1 bis 2.4), die nebeneinander angeordnet sind, eine Strom und Wärme leitende Schicht (4) sowie ein Wärmeabfuhrelement (3) für alle Transistorelemente, wobei die Transistorelemente, in Mesastruktur, aus einem Stapel verschiedener Schichten gebildet sind, die als Sub-Kollektorschicht (SC), Kollektorschicht (C), Basisschicht (B) und Emitterschicht (E) bezeichnet werden, wobei das Bauteil **dadurch gekennzeichnet ist, dass:**

   - das Bauteil zwei passive und thermisch leitende Schaltungen (P1 und P2) umfasst, die auf beiden Seiten der Transistorelemente liegen, wobei die Schaltungen die gleiche Struktur und die gleiche Zusammensetzung wie die Transistorelemente aufweisen, wobei jedes Transistorelement außerdem auf seinem oberen Teil eine elektrische Emitterkontaktschicht (CE ; e.1 bis e.4) aufweist;
   - die elektrische Emitterkontaktschicht jedes Transistorelements mit der Strom und Wärme leitenden Schicht überzogen ist, über der ein Wärmeabfuhrelement in Kontakt mit der leitenden Schicht liegt;
   - das Wärmeabfuhrelement eine plane Form aufweist;
   - die Schaltungen ebenfalls mit der Strom und Wärme leitenden Schicht überzogen sind;
   - es ferner ein isolierendes Material umfasst, das die Räume zwischen den verschiedenen Transistorelementen und die Räume zwischen den Transistorelementen und den Schaltungen ausfällt, wobei das isolierende Material mit der Oberfläche der Emitterkontaktschichten der Transistorelemente und der Oberfläche der Schaltungen bündig ist, so dass die Baugruppe eine plane Oberfläche (6) bildet.

2. Bauteil nach Anspruch 1, **dadurch gekennzeichnet, dass** das Wärmeabfuhrelement eine Diamantplatte ist.

3. Bauteil nach Anspruch 2, **dadurch gekennzeichnet, dass** die Diamantplatte auf die Stapel des Transistors und auf die Schaltungen gelötet ist.

4. Bauteil nach Anspruch 3, **dadurch gekennzeichnet, dass** das Lösten mit Hilfe einer Legierung auf Zinnbasis ausgeführt wird.

5. Bauteil nach Anspruch 2, **dadurch gekennzeichnet, dass** die Diamantplatte aus polykristallinem Diamant ist, und dass ihre Kontaktfläche mit den Schichtstapeln und den Schaltungen metallisiert ist.

6. Bauteil nach einem der vorergehenden Ansprüche, **dadurch gekennzeichnet, dass** das Wärmeabfuhrelement durch Aufwachsen eines Materials ausgeführt wird, das eine Wärmeeindringzahl nahe der von Diamant, in der Größenordnung von 4, besitzt.

7. Verfahren zur Ausführung eines Heterobipolar-Transistors (TR1, TR2, TR3), umfassend die folgenden Phasen:

   ■ Ausführen auf einem Substrat (1) der regelmäßigen Abfolge der folgenden Schichten mit den Materialien, die als Beispiel in Klammern angegeben sind:

- Sub-Kollektorschicht (GaAs: n+)
- Kollektorschicht (GaAs: μ)
- Basisschicht
- Emitterschicht (Ga1nP: n)

■ Ätzen der verschiedenen Schichten, die oben definiert sind, um Stapel mit Mesastruktur auszuführen;

■ Ausführen von Basiskontakten (CB1, CB2) und von Kollektorkontakten (CC1, CC2) ;

■ Ausführen von Emitterkontakten (CE; e1 bis e4) an bestimmten Stapeln, um Transistorelemente zu formen (2.1 bis 2.4), wobei die anderen Stapel passive (P1 und P2) und Wärme leitende Schaltungen bilden;

■ Ausfüllen der freien Räume zwischen den verschiedenen Transistorelementen und zwischen den Transistorelementen und den Schaltungen, mit Hilfe eines isolierenden Materials, und Planmachen, um eine freie Oberfläche (6) zu erhalten, die bündig mit den Oberflächen der Transistorselemente und den Schaltungen abschließt;

■ Abscheidung einer Strom und Wärme leitenden Schicht (4), die eine Wärmesenke bildet, die einen Kontakt mit den Oberflächen der Transistorselemente und den Schaltungen herstellt, wobei die Oberflächen der Transistoren elektrische Emitterkontaktschichten sind;

■ Befestigen einer Wärmeabfuhrplatte (3) in Kontakt mit der Wärmesenkenschicht.

FIG.1

FIG.2

FIG.3

FIG.4

EP 1 110 242 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 9706682
- FR 2764118 A
- EP 0756322 A